(19) Europäisches Patentamt
European Patent Office
Office européen des brevets

(11) Publication number: **0 040 905**
**B1**

# (12) EUROPEAN PATENT SPECIFICATION

(45) Date of publication of patent specification: **14.08.85**

(51) Int. Cl.$^4$: **H 01 L 21/48**, H 01 L 23/14, H 01 L 23/54, H 03 K 3/00

(21) Application number: **81301493.3**

(22) Date of filing: **07.04.81**

## (54) The manufacture of ceramic circuit substrates.

(30) Priority: **26.05.80 JP 69818/80**

(43) Date of publication of application:
**02.12.81 Bulletin 81/48**

(45) Publication of the grant of the patent:
**14.08.85 Bulletin 85/33**

(84) Designated Contracting States:
**DE FR GB**

(56) References cited:
**EP-A-0 011 013**
**US-A-3 541 222**
**US-A-3 762 029**

**IBM TECHNICAL DISCLOSURE BULLETIN, volume 20, no. 4, September 1977 NEW YORK (US) T.J. COVHRAN et al.: "Automated punch apparatus for forming via holes in a ceramic green sheet", pages 1379-1380**
**McGraw Hill, Encyclopedia of Science and Technology, 1977, Vol. 10, pages 544 to 546**

(73) Proprietor: **FUJITSU LIMITED**
**1015, Kamikodanaka Nakahara-ku**
**Kawasaki-shi Kanagawa 211 (JP)**

(72) Inventor: **Yokouchi, Kishio**
**2-28-15, Higashimachi Koganei-shi**
**Tokyo 184 (JP)**
Inventor: **Ogawa, Hiromi**
**3-9-11, Yako Tsurumi-ku**
**Yokohama-shi Kanagawa 230 (JP)**
Inventor: **Yokoyama, Hiromitsu**
**5-12, Tsutsujigaoka Midori-ku**
**Yokohama-shi Kanagawa 227 (JP)**
Inventor: **Kamehara, Nobuo**
**2300, Yamazaki-cho Machida-shi**
**Tokyo, 194-01 (JP)**
Inventor: **Niwa, Koichi**
**5-34-7-3, Nagayama Tama-shi**
**Tokyo, 192-02 (JP)**
Inventor: **Murakawa, Kyohei**
**775-25, Kanagaya Asahi-ku**
**Yokohama-shi Kanagawa 241 (JP)**

(74) Representative: **Sunderland, James Harry et al**
**HASELTINE LAKE & CO Hazlitt House 28**
**Southampton Buildings Chancery Lane**
**London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

**EP 0 040 905 B1**

Courier Press, Leamington Spa, England.

**Description**

This invention relates to the manufacture of ceramic circuit substrates, for example a method of forming semiconductor elements such as IC's, LSI's, etc., and for instance a method of manufacturing a ceramic circuit substrate having via holes for interlayer connection.

Progress in computers, involving reduction in size and increased integration density, has led to a trend in which circuit substrates are more and more micro-miniaturized in pattern and fantastically multi-layered.

Currently, in order to provide circuit substrates of this type, so-called resin substrates are employed, in which a resin such as epoxy, polyimide etc. is impregnated into a glass cloth or mesh.

Recently, however, ceramic substrates, which have various excellent attributes, have received attention, rather than resin substrates, and research and investigation is now taking place in laboratories around the world.

A ceramic substrate has various properties which offer the possibility of realisation of a high density circuit pattern; the substrate exhibits little thermal aging variation, it has a high tolerance for external stress and can sustain a high surface smoothness, since the material itself is very stable. Therefore, bare semiconductor element chips can be directly connected and mounted, by a wire bonding method for example, on a ceramic substrate. This is unlike a conventional method whereby parts are mounted on a resin substrate. In such a conventional method, moulded IC's, ceramic LSI packages, are mounted on a resin substrate.

As a result it is possible to improve the mounting density of elements to be mounted on a substrate, in addition to the micro-miniaturization of circuit patterns. Moreover, since, with a ceramic substrate, an inter-layer connecting method is employed in which a via hole is provided, namely a hole is bored in a substrate and then the hole is filled with metallic paste (unlike an inter-layer connecting method in which a through hole is bored in a resin substrate, namely a through hole is bored after layer stacking and then a conductive plating process is effected for this through hole) it can provide an advantage in that a blind through hole can be formed very easily and as a result an increased wiring redundancy in the thickness direction of the substrate can be provided. A circuit structure utilizing a ceramic substrate is disclosed, for example, in "IBM multi-chip multi-layer ceramic module for LSI chips—Design for performance and density—" of "IEEE Transaction, 1980 Vol. C HMT 3, No. 3, No. 1 March, 1980".

However, a ceramic circuit substrate of this type has disadvantages in that formation of a via hole as mentioned above has been troublesome and, moreover, highly accurate via hole formation has not been achieved.

Formation of a via hole has usually required a two step process—for example, boring into the substrate and then filling the hole so formed with metallic paste.

The boring process can be performed using a laser beam for example but a relatively long time is required for beam irradiation and beam deflection scanning.

Filling with metallic paste cannot be carried out accurately and firmly.

According to the present invention there is provided a method of forming a ceramic circuit substrate, characterised in that a conductive ball is pressed into and embedded in a ceramic green sheet used to form the substrate.

The present invention further provides a ceramic substrate formed by such a method, and a semiconductor device including a substrate formed by such a method.

An embodiment of the present invention provides a novel method of forming a ceramic circuit substrate in which via hole formation is accomplished in one step.

An embodiment of the present invention can provide a method of forming a ceramic circuit substrate which can assure the formation of a large number of via holes with excellent accuracy.

An embodiment of the present invention can provide a method of forming a ceramic circuit substrate suitable for automatic production use, and therefore suitable for use in mass-production.

An embodiment of the present invention offers a solution to the problems of the conventional method of forming a ceramic circuit substrate as explained above, and comprises the following processes; a ball arranging plate setting process wherein a ball arranging plate, providing many holes, larger in diameter than the outer diameter of conductive balls to be employed, is set on a ceramic green sheet placed on a tray; a contact process wherein the ceramic green sheet and plate are placed in close contact; a filling process wherein the holes in the plate are filled with the conductive balls; a pressurizing or compression process wherein the conductive balls, from the holes, are pressed into and embedded in the ceramic green sheet; and a baking process wherein the ceramic green sheet is baked.

In an embodiment of the present invention, conductive balls made of gold are arranged in an orderly fashion on a ceramic green sheet using a ball arranging plate, the conductive balls are pressured or compressed, all at one time, into the ceramic green sheet under conditions such that the plate and green sheet are brought into close contact by an external force, and thereafter the green sheet with embedded pressed-in balls is baked.

Reference is made, by way of example, to the accompanying drawings, in which:—

Figure 1 is a schematic sectional diagram for assistance in explanation of a conventional method of forming a ceramic circuit substrate;

Figure 2 is a schematic sectional diagram of apparatus, for forming via holes in a ceramic

circuit substrate, as employed in a method embodying the present invention;

Figure 3 is an enlarged sectional view of a part of the apparatus of Figure 2, in a first condition;

Figure 4 is an enlarged sectional view of a part of the apparatus of Figure 2, in a second condition;

Figure 5, (a) to (e), illustrates a practical means of producing gold balls;

Figures 6 to 9 are respective schematic sectional views for explanation of problems that could arise in apparatus as shown in Figure 2;

Figure 10 is a schematic sectional view illustrating the disposition of balls pressed into a ceramic green sheet by pressurization when a problem as illustrated in Figure 9 occurs;

Figures 11 and 12 are respective schematic sectional views of apparatuses employed in methods embodying the present invention;

Figure 13 is a schematic sectional view; and Figure 14 is a plan view, of an apparatus empolyed in a method embodying the present invention;

Figure 15 is a schematic sectional view illustrating the shape of a force piston pin used in apparatus employed in a method embodying the present invention;

Figure 16 is a sectional view of a ceramic green sheet with balls embedded therein;

Figure 17 is a schematic sectional view of apparatus employed in the method embodying the present invention;

Figure 18 is an enlarged sectional view of a part of the apparatus of Figure 17; and

Figure 19 is a plan view of a ceramic green sheet obtained through the use of the apparatus of Figures 17 and 18.

As semiconductor elements such as IC's and LSI's have achieved higher integration densities, a circuit substrate for mounting packaged elements must provide a higher wiring density. For this purpose, a study of lead wire width and mutli-layer structures in conductor circuits has been made.

The formation of via holes for inter-layer connection in a multi-layered ceramic circuit substrate has usually involved two processes, a boring process and a filling process.

A puncher or drill or laser beam apparatus is used for boring a raw substrate sheet.

However, boring by the methods mentioned above is subject to limitation. For example, boring by a puncher or drill is limited to a minimum hole diameter of 0.5 mmϕ and it is difficult to obtain a punching mould and a drill which will assure that the boring is accomplished with high accuracy. On the other hand, the use of a laser beam facilitates boring a hole of a diameter of 0.1 mmϕ but requires a relatively long boring period, resulting in inadequate fine machining and difficulty in achieving desired accuracy.

After the boring of via holes by a method as mentioned above, a bored ceramic green sheet 2 is mounted on a tray 1, and a hole filling screen 3 is positioned, separately from the positioning of the green sheet 2, with the screen 3 and green sheet 2 in close contact, then conductor paste 4 is coated internally of holes 6 in the raw green sheet 2 by movement of a stage 5 over the screen 3, as shown in Figure 1. It is difficult to align the holes 6 bored in the raw green sheet 2 with a proper coating position 7 of the screen 3 (that is, to align the holes in sheet 2 with those in screen 3) and poor alignment accuracy brings about a problem on micro-miniaturization of via holes.

In an embodiment of the present invention, boring and filling are carried out at one time, and via holes are formed in a ceramic green sheet in a single process.

Basically, in an embodiment of the present invention many conductive balls are arranged on a ceramic green sheet, and they are pressed upon, all at one time, and thereby pressed into and embedded in the green sheet.

Figure 2 shows apparatus for forming via holes in accordance with an embodiment of the present invention.

In Figure 2, 10 is a force piston, 8 is a ball arranging plate, 9 indicates Au (gold) balls of 0.1 mmϕ (0.1 mm diameter), 2 is a ceramic green sheet of a (pre-baking) thickness of 0.12 mm, 1 is a tray, 1a indicates dents in the tray, and 11 indicates alignment pins (the tray has four corners, at each of which an alignment pin is provided).

First of all, the green sheet 2 is placed on the tray 1, and the ball arranging plate 8 is placed on the green sheet 2. At this time, since alignment pins 11 pass through the green sheet 2 and through alignment holes pre-formed in the ball arranging plate 8, the green sheet 2 and ball arranging plate 8 are positioned to a desired specific relative disposition.

Then, many metallic balls 9, made of gold, are placed on the ball arranging plate 8 and the plate is then vibrated:— thereby tapered holes provided in the ball arranging plate 8 are automatically filled by the balls. Excess metallic balls 9 are removed, and the force piston is placed above the ball arranging plate 8, engaged with the alignment pins 11, at the four corners of the tray 1.

Figure 3 is a sectional view, to a larger scale, of a part of the apparatus of Figure 2, showing the gold balls in the holes in plate 8, with the piston 10 above the plate.

Next, the apparatus as a whole is heated up to 80°C and pressurized (compressed) for five minutes under a pressure of 100 $kg/cm^2$ by means of a hydraulic press machine. Thereby, as shown in Figure 4, the metallic balls 9 drop into the dents 1a (0.05 mm deep in this embodiment) of the tray 1; the upper parts of the metallic balls 9 come into contact with the force piston 10, providing a clearance C between the force piston 10 and the green sheet 2. Thus, little force is exerted by the ball arranging plate 8 on the green sheet 2.

In a next step, when the force piston 10, ball arranging plate 8, and tray 1 are all reset, via holes

where metallic balls 9 are filled at the inside of green sheet 2 can be formed.

On a green sheet in which via holes are formed as explained above, a thick film conductor wiring pattern is, for example, formed and after stacking in a press to form a multi-layered body, baking at a temperature of 900°C is carried out, and thereby a multi-layered circuit substrate can be obtained.

The use of an excessively high temperature when placing the metallic balls 9 into the green sheet 2 will cause deterioration of the green sheet 2 and therefore the optimum temperature is 80°C to 100°C. Moreover, materials which are resistive to heat and suitable for etching are appropriate for the force piston 10, ball arranging plate 8 and tray 1. For example, these items can be obtained by etching stainless steel or Mo plate, etc. A suitable pressure to be applied for forcing the metallic balls into the green sheet is one within the range 100 to 150 kg/cm$^2$. If a pressure higher than this is used metallic balls (of gold) may be destroyed.

Of course, it is desirable that the metallic balls all have the same size. However, balls of gold currently obtained on the market have a poor uniformity of size. It is thus desirable to provide a means of forming metallic balls having excellent size uniformity.

To this end, a fine lead (or wire), of gold (Au), for example, of a purity of 99.9% is cut into segments of predetermined length, these segments are arranged on a heat resistant plate such as an alumina block, this plate is kept horizontal in a furnace at atmospheric pressure, and the furnace temperature is increased up to 1080°C (a temperature higher than the melting point of gold) at a rate of 700°C/hour, this temperature is held for 10 minutes. Thereby, the gold segments cut to predetermined length are melted on the plate and form into spheres.

When furnace temperature is reduced to normal temperature at a rate of 500°C/hour, the melted gold solidifies, thus forming gold balls.

Figure 5 shows a practical example for the production of gold balls based on the principle described above.

In Figure 5, (a) illustrates a heat resistant substrate 20. First, a bonding agent 21 is coated on the substrate 20 as indicated in Figure 5, (b). Then, many fine gold leads 9′ are arranged as shown in Figure 5, (c) and these fine gold leads 9′ are cut into segments of the desired length. Since the fine gold leads 9′ adhere to the substrate because of the presence of the bonding agent 21, cutting can be effected without disturbing the arrangement of the fine gold leads.

Then, the substrate 20 is subjected to a thermal process, in a manner as explained above, together with the cut fine gold leads. Thereby, gold balls 9 can be obtained as shown in Figure 5, (e).

Gold balls of a desired diameter can be obtained by properly selecting the length (the cutting length) of the segments into which the fine gold leads are cut (bearing in mind the lead diameter). The relationship between the size of ball obtained and cutting length is shown in the table below. For example, when fine gold lead of a diameter of 100ϕ μm is cut into segments of length 34 μm, gold balls of a size 80ϕμm (80 μm diameter) can be obtained.

| | Cutting length of Au fine lead (μm) | | |
|---|---|---|---|
| Diameter of Au fine lead used→ | 100 | 50 | 30 |
| Ball diameter ↓ | | | |
| 80 μm | 34 | 136 | 379 |
| 100 | 66 | 266 | 740 |
| 120 | 115 | 460 | 1280 |
| 150 | 225 | 900 | 2300 |
| 200 | 533 | 2133 | 5925 |

The surface roughness of various substrates used for producing gold balls is as follows.

| Kind of substrate | Roughness | Adequacy of balls produced |
|---|---|---|
| FGA substrate | 0.15 μm | Adequate |
| Marketed substrate | 0.4 | Adequate |
| Marketed block | 10 | Adequate |

When the surface roughness is within the range from $R_{max}$ 0.1 to 10 μm, balls can be obtained, but optimum roughness is $R_{max}$ 7 to 10 μm.

The gold balls thus obtained have only a small particle size distribution and have the desired ball diameter.

Having obtained metallic gold balls of such a high accuracy, the next object is the accurate arrangement of the metallic balls. For the arrangement of the balls, a ball arranging plate 8 as described above is used.

If this ball arranging plate 8 is too thin, as shown in Figure 6, the metallic balls 9 are not properly guided into the holes in the ball arranging plate 8, and balls (e.g. 9'') can escape from the holes.

However, if plate 8 is too thick, as shown in Figure 7, two or more balls 9, 9a can enter one hole in the ball arranging plate 8, resulting in inconvenience.

Therefore, the ball arranging plate 8 is required to have a thickness similar to the diameter of the balls 9.

However, meeting this requirement results in the following problems. Since the diameter of metallic balls 9 is as small as 80 μm, for example, when the ball arranging plate 8 used for arranging the metallic balls has a thickness similar to the ball diameter, deformation of the plate 8 can occur under only a weak external force.

One form of deformation can result in a clearance being formed between the ball arranging plate 8 and the green sheet 2, which should essentially be placed in close contact, with the result that metallic balls 9 are not carried accurately in the holes of the ball arranging plate 8, with a problem as indicated by ball 9''' in Figure 8 occurring, resulting in balls not being placed in the specified locations in the green sheet 2.

Figure 9 shows another form of deformation, in which the ball arranging plate 8 is deformed in a direction opposite to the direction of deformation in Figure 8. In this case also, metallic balls 9 are not arranged at desired specified locations. As a result, as shown in Figure 10, metallic balls 9 are embedded in a green sheet 2 in locations displaced by δ, δ' respectively from the desired locations, and stacking together of a plurality of such green sheets 2 will give rise to a disadvantage in that sufficient electrical continuity between upper and lower layers cannot be obtained.

Thus, a method embodying the present invention for forming a ceramic circuit substrate comprises a step for preventing generation of such displacement of balls, namely a close-contact process whereby the green sheet 2 is placed in close contact with the ball arranging plate 8 for example by applying an external force such as a pneumatic force or a vacuum force or a magnetic force etc. for example to the green sheet 2.

Figure 11 is a sectional view of apparatus used in an embodiment of the present invention for providing the above-mentioned close-contact process.

In Figure 11, 1 is a tray, 12 indicates a plurality of through holes bored in the tray 1, 13 indicates compressed air, 10a indicates projecting portions (pins) of a force piston 10 which projecting portions (pins) are provided to correspond to holes in the ball arranging plate 8.

Green sheet 2 is placed on the tray 1 having the structure as described above, and moreover the ball arranging plate 8 is placed on the green sheet 2. Under these conditions, compressed air 13 is supplied through the through holes 12, and the green sheet 2 freely deforms to conform to the pressure of the compressed air, because the green sheet is essentially soft, and comes into close contact with the surface of ball arranging plate 8. Even when the pressure of the compressed air is comparatively small, close contact between the green sheet 2 and the ball arranging plate 8 can be assured.

When the green sheet 2 and the ball arranging plate 8 are placed in close contact, balls 9 are arranged centrally of the holes provided in the ball arranging plate 8. Thus, the balls are correctly placed at specified locations in the green sheet 2.

Moreover, since the compressed air 13 applies uniform pressure to each part of the green sheet 2, the green sheet 2 does not suffer damage, unlike a case in which it is placed to contact with a solid substance, and, additionally, local clearances between the green sheet 2 and the ball arranging plate 8 do not occur.

Figure 12 is a sectional view of another apparatus used in an embodiment of the present invention for the above-mentioned close contact process.

In Figure 12, 15 is an electro-magnet provided in the tray 1, 8a is a ball arranging plate consisting of a magnetic body. Other elements are the same as those in Figure 2. An upper end surface of the electromagnet 15 is at the same level as the upper end surface of the tray 1.

The green sheet 2 is provided at a specified position on the upper end surface of the tray having the electro-magnet 15, by means of guide pins 11, 11'. Thereafter the ball arranging plate 8a is set at the specified position on the green sheet 2, also through engagement with the guide pins 11, 11'.

Thereafter, the metallic balls 9 are inserted and arranged in the holes in the ball arranging plate 8a.

Upon completion of the arrangement of the metallic balls 9, a current is applied to the electro-magnet 15 provided on the tray 1, and the magnet attracts the ball arranging plate 8a to the tray 1 with an electro-magnetic force.

Since the ball arranging plate 8a is attracted to the tray 1 by a magnetic force, clearances between the ball arranging plate 8a and the green sheet 2 do not arise, and they are placed in close contact. Therefore, the metallic balls 9 are accurately positioned. Under these conditions, the balls 9 are pressed down by the force piston

as in the case of Figure 11. Thus, the metallic balls 9 are accurately pressed into and embedded in the green sheet 2 by means of the force piston pins without displacement of the balls. When embedding is complete, the magnet 15 is released from activation, and thereby the ball arranging plate 8a, and the green sheet 2 in which metallic balls are embedded, can be reset easily.

Employment of an electro-magnet results in an advantage in that the structure of the tray 1 is simplified and in that the tray 1 does not require any external elements other than a power supply and a switch.

Figure 13 and Figure 14 illustrate a third apparatus used in an embodiment of the present invention for the above-mentioned close contact process. Figure 13 is a vertical sectional view and Figure 14 is a plan view.

In Figures 13 and 14, 16, 16′ indicate a double-ring groove provided at the upper surface of the tray 1, 17 is a suction hole linked to the grooves 16, 16′, 18 is a vacuum pump which applies a negative pressure to the suction hole 17. Other parts are as in Figure 2.

Prior to a contact process effected using apparatus of the structure shown in Figures 13 and 14, the green sheet 2 is placed in an indented area in the tray 1 surrounded by the grooves 16, 16′. Then, the ball arranging plate 8 is mounted in such a way as to cover the green sheet 2 and the grooves 16, 16′ in the tray 1.

Thereafter, the vacuum pump 18 is started. Thus, a negative pressure generated by the vacuum pump 18 is applied to the grooves 16, 16′ through the suction hole 17 and thus the ball arranging plate 8 is attracted to the tray 1 and placed in close contact with the green sheet 2.

When the metallic balls 9 are located in the holes in the ball arranging plate 8 under these conditions, the metallic balls 9 are located centrally of the ball arranging plate 8 and are positioned accurately.

As explained with reference to the three apparatuses described above, in a contact process of an embodiment of the present invention, uniform close contact is provided between the green sheet 2 and ball arranging plate 8 and thereby clearances between the green sheet 2 and the ball arranging plate 8 can be eliminated, thus making possible accurate positional arrangement of the metallic balls. When metallic balls, from accurate positions, are pressed into and embedded in a green sheet, if a plurality of green sheets are stacked together, displacement of metallic balls does not occur between adjacent layers, assuring satisfactory electrical continuity.

It is required that the metallic balls arranged on the green sheet 2 must all move vertically of the surface of tray 1 into the green sheet 2 and that they must be embedded into the green sheet to such a distance as to cause opposite ends of the metallic balls to be exposed at opposite surfaces of the green sheet 2.

For this purpose, it is desirable that the force piston has a sufficient height and has pins the end points of which are flat.

As shown in Figure 15, if a tapered pin as shown at 10b or 10c is used, as compared with a case in which a pin as shown at 10a is used, not only can the metallic ball 9 not be embedded vertically with accuracy, but the end of the metallic ball 9 may not be exposed at the rear side of green sheet 2 as a result of insufficient embedding distance.

Pins on the force piston are formed by chemical etching, which meets the requirements of accuracy and production cost. In etching, since a pin is formed step by step from its end point to its root portion, the nearer a part of the pin is to the end point, the longer it is immersed in chemical etching solution and, as shown in Figure 15, the resulting pin may be tapered or, in an extreme case, conically formed.

An embodiment of this invention offers a preferred solution to the problem of forming a force piston pin without a taper.

Namely an embodiment of the present invention involves the use of photo-sensitive glass, having a glass composition of the $SiO_2$—$Li_2O$—$Al_2O_3$ system, as the material of which the force piston is made. A desirable composition for such photo-sensitive glass is illustrated in the following table, in which figures are parts by weight.

| | |
|---|---|
| $SiO_2$ | 81.0 |
| $LiCO_3$ | 30.9 |
| $Al_2O_3$ | 4.3 |
| $KNO_3$ | 5.4 |
| $CeO_2$ | 0.03 |
| Au | 0.05 |

As raw material, a powder having the composition mentioned above is prepared in a platinum vessel, and the vessel is heated under 1450°C for three hours in order to fuse the powder. Thereafter, the fused material is transferred to a mould of carbon and rapidly cooled. Thereby, a glass basic material of

$$SiO_2—Li_2O—Al_2O_3$$

composition can be obtained.

After irradiating areas other than those which are to form pins 10a of the glass base material with ultra-violet rays, using a mask for irradiation, the base material is heated for two hours under 620°C and then it is etched by being dipped into 10% fluoric acid solution. Thereby, non-tapered pins can be formed.

The above mentioned

$$SiO_2—Li_2O—Al_2O_3$$

system glass shows a difference in solubility with regard to fluoric acid of about 30 times between

those areas irradiated and those areas not irradiated by ultra-violet rays. Therefore, only irradiated parts are etched, non-irradiated parts are little etched. Therefore, a force piston having pins of accurate cylindrical form can be obtained. Pressing of metallic balls 9 into a green sheet pushes aside material of the green sheet of the same volume as that of the metallic balls.

Thereby, as shown in Figure 16, a chip 2a of green sheet often remains at a rear surface 2c' of the green sheet, opposite to the surface of the green sheet 2 from which balls 9 are embedded, after embedding is completed. If such a sheet chip 2a remains in place, a faulty discontinuity can occur between upper and lower circuit patterns. As a result, satisfactory via holes may not be formed, reducing production yield and interfering with the multi-layer structure of a substrate.

For this reason, such a sheet chip 2a must be removed and such removal can be effected at the time when the metallic balls are pressed in, in an embodiment of the present invention.

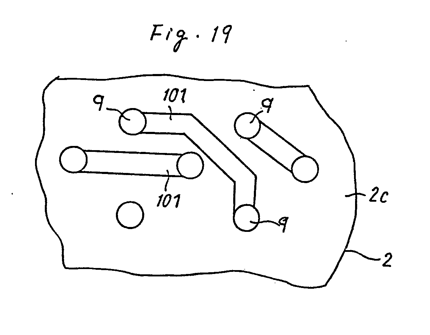

Figure 17 and Figure 18 illustrate apparatus for embedding metallic balls which provides for removal of such sheet chips 2a. Figure 17 is a sectional view of the apparatus as a whole, whilst Figure 18 is an enlarged sectional view of a part of the apparatus in the vicinity of the metallic balls 9.

As shown in Figure 17, this apparatus has a tray 1, which has indentations 1a at areas which correspond to areas at which via holes must be formed as shown in Figure 2. Each indentation 1a is provided with a suction hole 19 in such a way as the one end is opened, the suction holes 19 are brought together within the tray 1 and are connected to appropriate means such as a vacuum pump. As shown in Figure 17, the tray 1 is provided with vertical guide pins 11, 11' and on these guide pins the green sheet 2, having an electrical insulation property, can be freely engaged via guide holes 2b, 2b'. On the green sheet 2, ball arranging plate 8 is provided, freely engaged on the guide pins 11, 11' via guide holes of which one, 8a, is shown in Fig. 17, and the ball arranging plate 8 is provided with many cylindrical positioning holes 8b which correspond to the indentations 1a in the tray as shown in Figure 18. On the ball arranging plate 8, as shown in Figure 17, the force piston 10 is provided, freely engaged with the guide pins 11, 11' via guide holes 10d, and the force piston 10 is provided with many pins 10a corresponding to the positioning holes 8b of the ball arranging plate 8, as a result corresponding to the indentations 1a of the tray 1.

Since the metallic ball arranging apparatus has a structure as mentioned above, when forming via holes in the green sheet 2, as shown in Figure 17, the green sheet 2 in which the via holes are to be formed is set on the tray 1 with the guide holes 2b, 2b' in the sheet 2 being engaged with the guide pins 11, 11'. Moreover, the ball arranging plate 8 is also placed on the green sheet 2 with guide holes engaged with the guide pins 11, 11'. Only one such guide hole, 8a, is shown. Under these conditions, as shown in Figure 18, conductive metallic balls 9, consisting of gold, are arranged in respective positioning holes 8b of the ball arranging plate 8 as shown in Figure 18, and then the force piston 10 is dropped downwards as shown in Figure 17 with its guide holes 10d, 10d engaged with the guide pins 11, 11'. Thereby, as shown in Figure 17, the pins 10a of the force piston 10 come into contact with the metallic balls 9 in the positioning holes 8b. When the force piston 10 is further moved downwards in the Figures, the balls 9 are pressed into specified via hole forming positions on the green sheet 2, being guided into cylindrical positioning holes 8b. At this time, as shown in Figure 16, excess sheet chips 2a are gradually pushed out into the indentations of tray 1 from the surface 2c' of the green sheet 2 as the balls 9 are pressed into the sheet 2, but since the indentations 1a are provided with suction holes 19 connected to a vacuum pump, for example, sheet chips 2a are sucked through suction holes 19 and thereby sheet chips do not remain on the green sheet 2. When the force piston 10 and the ball arranging plate 8 come into contact and the force piston 10 can no longer move downwards in the Figure, the metallic balls 9 are embedded at specified positions in the green sheet 2. Meanwhile, the force of the vacuum pump on the green sheet 2, exerted through the suction holes 19, absorbs the sheet chips 2a but is not so high as to attract the metallic balls 9 in the green sheet 2. Therefore, the metallic balls 9 are held at specified positions in the green sheet, namely at locations where parts of each ball 9 are equally exposed at opposite surfaces 2c, 2c' of the green sheet 2. Under these conditions, as shown in Figure 19, a pattern 101 which connects metallic balls 9 is formed on the surface 2c of the green sheet 2. Substrates provided as described above are stacked and pressed into a multilayer substrate body. Thereby, a pattern layer structure consisting of many patterns 101 is formed between stacked green sheets 2 and the specified patterns are electrically connected by means of the metallic balls 9 at adjacent patterns formed sandwiching a green sheet 2. At this time, since no excess sheet chips 2a remain on a green sheet 2, the metallic balls 9 are capable of accurately connecting the specified patterns. Thus, a multilayered green sheet 2 is baked at a high temperature and thereby a ceramic multi-layer circuit substrate can be completed.

Embodiments of the present invention as described above cannot only be used individually but can also be used in combination. For example, the compressed air supply means used in the embodiment of Figure 11 can be used in combination with the embodiment shown in Figure 12. Moreover, the electro-magnet 15 used in Figure 12 can also be used in combination with the embodiment shown in Figure 13.

An embodiment of this invention provides a method of forming a ceramic circuit substrate which permits elements to be mounted with a high integration density.

A method of forming a ceramic circuit substrate embodying the present invention can offer a ceramic circuit substrate having highly accurate, high integration density wiring patterns, with good wiring continuity.

Metallic conductive balls are used to connect conductive wiring patterns on upper and lower layers of a green sheet, thus:—

a ball arranging plate having many holes therein is placed on a green sheet with the plate and sheet in uniform close contact;

the holes are filled with the conductive balls;

the conductive balls are pressed by compression into the green sheet; and

the green sheet is baked.

In general, an embodiment of the present invention concerns the forcing of one or more conductive balls into a substrate to provide, as it were, an automatically filled through hole.

## Claims

1. A method of forming a ceramic circuit substrate, characterised in that a conductive ball is pressed into and embedded in a ceramic green sheet used to form the substrate.

2. A method as claimed in claim 1, wherein a ball arranging plate having many holes therein, into which conductive balls will fit, is placed on the ceramic green sheet, which is being carried by a tray, the ball arranging plate and the ceramic green sheet are brought into close contact, conductive balls are introduced into the holes in the ball arranging plate, the conductive balls are pressed into the ceramic green sheet to embed them therein, and the ceramic green sheet is baked.

3. A method as claimed in claim 2, wherein the ceramic green sheet, the conductive balls, the ball arranging plate and the tray are maintained at 80°C to 100°C whilst the conductive balls are pressed into the ceramic green sheet under a pressure of 100 $kg/cm^2$ to 150 $kg/cm^2$.

4. A method as claimed in claim 2 or 3, wherein close contact between the ball arranging plate and the ceramic green sheet is brought about by the application of an external force to the ball arranging plate and/or the ceramic green sheet by one of the following means:—

(a) the introduction of compressed air between the tray and the ceramic green sheet, to urge the ceramic green sheet into contact with the ball arranging plate;

(b) the application of a magnetic force to the ball arranging plate, which is of a magnetic material, directed towards the tray side of the ceramic green sheet, to urge the ball arranging plate into contact with the ceramic green sheet;

(c) the application of a suction force (a vacuum or a negative pressure) between the tray and the ball arranging plate at a region outside the perimeter of the ceramic green sheet, to urge the tray and ball arranging plate together (with the ceramic green sheet between).

5. A method as claimed in claim 2, 3 or 4, wherein debris produced on the tray side of the ceramic green sheet as a result of displacement of material of the ceramic green sheet when the conductive balls are pressed in is removed by suction, the tray being provided with suction holes at positions corresponding to positions at which the conductive balls are to be pressed into the ceramic green sheet.

6. An apparatus for carrying out a method as claimed in claim 2, 3, 4 or 5, wherein the conductive balls are pressed into the ceramic green sheet by means of a force piston, having projections thereon in positions corresponding to the positions of the holes in the ball arranging plate, which projections are urged into the holes in the ball arranging plate.

7. An apparatus as claimed in claim 6, wherein the force piston is of a photo-sensitive glass material, the projections thereon being formed by chemical etching.

8. A method as claimed in any of claims 1 to 5, wherein the or each conductive ball is a metallic ball formed by a process comprising placing fine wire or lead of a metal on a carrier plate, cutting it into segments of a selected length, melting the segments, and resolidifying the melted segments, preferably the carrier plate being coated with a bonding agent for holding the fine wire or lead in position during cutting into segments.

9. A method as claimed in any of claims 1 to 5, or as claimed in claim 8, wherein the conductive balls are metallic balls of gold.

10. A method as claimed in claim 9, when read as appended to claim 8, wherein the segments are melted by heating to 1080°C at a rate of 700°C/hour, are held at 1080°C for 10 minutes, and are resolidified by cooling at a rate of 500°C/hour.

11. A method of forming a multi-layered ceramic substrate, wherein a plurality of ceramic green sheets with pressed-in conductive balls, each provided in accordance with a method as claimed in any of claims 1 to 5 and 8 to 10, are stacked together, baking of the green sheets being effected after such stacking.

12. A ceramic substrate with embedded balls made by a method as claimed in any of claims 1 to 5 and 8 to 11.

13. A semiconductor device including a ceramic substrate as claimed in claim 12.

## Patentansprüche

1. Verfahren zur Bildung keramischer Schaltungssubstrate, dadurch gekennzeichnet, daß eine leitende Kugel in ein keramisches grünes Blatt, welches zur Bildung des Substrats verwendet wird, hineingepreßt und eingebettet wird.

2. Verfahren nach Anspruch 1, bei welchem eine Kugel anordnende Platte, die viele Löcher hat, in welche leitende Kugeln hineinpassen, auf dem keramischen grünen Blatt plaziert wird, welches von einem Tablett getragen wird, das die die Kugeln anordnende Platte und das keramische grüne Blatt in engen Kontakt miteinander gebracht werden, die leitenden Kugeln in die

Löcher in der die Kugeln anordnenden Platte eingeführt werden, die leitenden Kugeln in das keramische grüne Blatt gegreßt werden, um sie dort einzubetten, und das keramische grüne Blatt gebacken wird.

3. Verfahren nach Anspruch 2, bei welchem das keramische grüne Blatt, die leitenden Kugeln, die die Kugeln anordnende Platte und das Tablett bei einer Temperatur von 80°C bis 100°C gehalten werden, während die leitenden Kugeln in das keramische grüne Blatt unter einem Druck von 100 $kg/cm^2$ bis 150 $kg/cm^2$ gepreßt werden.

4. Verfahren nach Anspruch 2 oder 3, bei welchem der enge Kontakt zwischen der die Kugeln anordnenden Platte und dem keramischen grünen Blatt durch Anwendung einer äußeren Kraft auf die die Kugeln anordnende Platte und/oder das keramische grüne Blatt mittels einer der folgenden Einrichtungen herbeigebracht wird:—

(a) die Einführung von Druckluft zwischen das Tablett und das keramische grüne Blatt, um das keramische grüne Blatt in engen Kontakt mit der die Kugeln anordnenden Platte zu drängen;

(b) die Anwendung einer magnetischen Kraft auf die die Kugeln anordnende Platte, die aus magnetischem Material ist, gerichtet zu der Tablettseite des keramischen Blattes, um die die Kugeln anordnende Platte in engen Kontakt mit dem keramischen grünen Blatt zu bringen;

(c) die Anwendung einer Saugkraft (eines Unterdruckes oder eines negativen Druckes) zwischen dem Tablett und der die Kugeln anordnenden Platte in einem Bereich außerhalb des Umfangs des keramischen grünen Blattes, um das Tablett und die die Kugeln anordnende Platte zusammenzudrängen (mit dem keramischen grünen Blatt dazwischen).

5. Verfahren nach Anspruch 2, 3 oder 4, bei welchem die Reste, die auf der Tablettseite des keramischen grünen Blattes infolge der Verschiebung des Materials des keramischen grünen Blattes erzeugt werden, wenn die leitenden Kugeln eingepreßt werden, durch Saugen entfernt werden, und das Tablatt Sauglöcher an Positionen aufweist, welche den Positionen entsprechen, bei denen die leitenden Kugeln in das keramische grüne Blatt gepreßt werden sollen.

6. Vorrichtung zur Durchführung eines Verfahrens nach einem der Ansprüche 2, 3, 4 oder 5, bei dem die leitenden Kugeln mittels eines Druckkolbens in das keramische grüne Blatt gepreßt werden, der in Positionen, die den Positionen der Löcher in der die Kugeln anordnenden Platte entsprechen, Vorsprünge aufweist, die in die Löcher in der die Kugeln anordnenden Platte hineingedrängt werden.

7. Vorrichtung nach Anspruch 6, bei welcher der Druckkolben aus fotosensitivem Glasmaterial besteht und seine Vorsprünge durch chemisches Ätzen gebildet sind.

8. Verfahren nach einem der Ansprüche 1 bis 5, bei welchem die oder jede leitende Kugel eine Metallkugel ist, welche durch ein Verfahren gebildet ist, das die Anordnung feiner Drähte oder Leitungen aus Metall auf einer Trägerplatte umfaßt, ihr Zerschneiden in Segmente von einer ausgewählten Länge, das Schmelzen der Segmente und die wiederverfestigung der geschmolzenen Segmente, wobei die Trägerplatte vorzugsweise mit einem Bindemittel überzogen ist, um die feinen Drähte oder Leitungen während des Schneidens in Segmente in ihrer Position zu halten.

9. Verfahren nach einem der Ansprüche 1 bis 5 oder nach Anspruch 8, bei welchem die leitenden Kugeln Metallkugeln aus Gold sind.

10. Verfahren nach Anspruch 9, in Verbindung mit Anspruch 8, bei welchem die Segmente durch Erhitzen auf 1080°C mit einer Geschwindigkeit von 700°C/Stunde geschmolzen werden, 10 Minuten lang bei 1080°C gehalten werden und dann durch Kühlen mit einer Geschwindigkeit von 500°C/Stunde wieder verfestigt werden.

11. Verfahren zur Bildung eines vielschichtigen keramischen Substrats, bei welchem eine Vielzahl von keramischen grünen Blättern mit eingepreßten leitenden Kugeln, die jeweils entsprechend einem Verfahren nach einem der Ansprüche 1 bis 5 oder 8 bis 10 hergestellt sind, zu einem Stapel geschichtet werden und die grünen Blätter nach dieser Stapelschichtung gebacken werden.

12. Keramisches Substrat mit eingebetteten Kugeln, hergestellt nach einem Verfahren wie es in irgendeinem der Ansprüche 1 bis 5 und 8 bis 11 beansprucht ist.

13. Halbleitervorrichtung mit einem keramischen Substrat nach Anspruch 12.

**Revendications**

1. Procédé de formation d'un substrat céramique pour circuit, caractérisé en ce qu'une bille conductrice est enfoncée et enrobée dans une feuille céramique crue utilisée pour la formation du substrat.

2. Procédé selon la revendication 1, dans lequel une plaque d'arrangement de billes ayant de nombreux trous formés à l'intérieur, dans lesquels les billes conductrices s'ajustent, est placée sur la feuille céramique crue qui est portée par un plateau, la plaque d'arrangement de billes et la feuille céramique crue sont mises en contact intime, des billes conductrices sont introduites dans les trous formés dans la plaque d'arrangement de billes, les billes conductrices sont enfoncées dans la feuille céramique crue afin qu'elles y soient enrobées et la feuille céramique crue est cuite.

3. Procédé selon la revendication 2, dans lequel la feuille céramique crue, les billes conductrices, la plaque d'arrangement de billes et le plateau sont maintenus à une température de 80 à 100°C pendant que les billes conductrices sont enfoncées dans la feuille céramique crue avec une pression comprise entre 100 et 150 $kgcm^2$.

4. Procédé selon l'une des revendications 2 et 3, dans lequel le contact intime entre la plaque d'arrangement de billes et la feuille céramique

crue est réalisé par application d'une force externe à la plaque d'arrangement de billes et/ou la feuille céramique crue, par l'une des moyens suivants:

(a) l'introduction d'air comprimé entre le plateau et la feuille céramique crue, afin que la feuille céramique crue soit repoussée au contact de la plaque d'arrangement de billes,

(b) l'application d'une force magnétique à la plaque d'arrangement de billes, qui est formée d'un matériau magnétique, dirigée vers le côté du plateau de la feuille céramique crue afin que la plaque d'arrangement de billes soit repoussée au contact de la feuille céramique crue,

(c) l'application d'une force d'aspiration (un vide ou une dépression) entre le plateau et la plaque d'arrangement de billes, dans une région qui se trouve en dehors du périmètre de la feuille céramique crue, afin que le plateau et la plaque d'arrangement de billes soient repoussés l'un contre l'autre (avec la feuille céramique crus entre eux).

5. Procédé selon l'une quelconque des revendications 2, 3 et 4, dans lequel les débris formés du côté du plateau de la feuille céramique crue, à la suite du déplacement de la matière de la feuille céramique crue lorsque les billes conductrices sont compressées dans la feuille, sont retirées par aspiration, le plateau ayant des trous d'aspiration dans des positions qui correspondent aux emplacements auxquels les billes conductrices doivent être enfoncées dans la feuille céramique crue.

6. Appareil destiné à la mise en oeuvre d'un procédé selon l'une quelconque des revendications 2, 3, 4 et 5, dans lequel les billes conductrices sont enfoncées dans la feuille céramique crue à l'aide d'un piston d'application de force, ayant des saillies dans des positions qui correspondent aux positions des trous dans la plaque d'arrangement de billes, ces saillies étant repoussées dans les trous formés dans la plaque d'arrangement de billes.

7. Appareil selon la revendication 6, dans lequel le piston d'application de force est formé d'un matériau de verre photosensible, les saillies de celui-ci étant formées par attaque chimique.

8. Procédé l'une quelconque des revendications 1 à 5, dans lequel la bille conductrice ou chaque bille conductrice est une bille métallique formée par un procédé comprenant la disposition d'un fil mince d'un métal sur une plaque de support, la découpe du fil en segments de longueur choisie, la fusion des segments, la ressolidification des segments fondus, la plaque de support étant de préférence revêtue d'un agent de liaison destiné à maintenir le mince fil en position pendant la découpe en segments.

9. Procédé selon l'une quelconque des revendications 1 à 5 ou selon la revendication 8, dans lequel les billes conductrices sont des billes métalliques d'or.

10. Procédé selon la revendication 9, dépendant de la revendication 8, dans lequel les segments sont fondus par chauffage à 1080°C à une vitesse de 700°C par heure, sont maintenus 10 minutes à 1080°C, et sont ressolidifiés par refroidissement à une vitesse de 500°C/heure.

11. Procédé de formation d'un substrat céramique multicouche, dans lequel plusieurs feuilles céramiques crues ayant des billes conductrices enfoncées, réalisées chacune par mise en oeuvre d'un procédé selon l'une quelconque des revendications 1 à 5 et 8 à 10, sont empilées, la cuisson des feuilles crues étant réalisée après cet empilement.

12. Substrat céramique ayant des billes enrobées, fabriqué par un procédé selon l'une quelconque des revendications 1 à 5 et 8 à 11.

13. Dispositif à semi-conducteur comprenant un substrat céramique selon la revendication 12.

Fig. 1

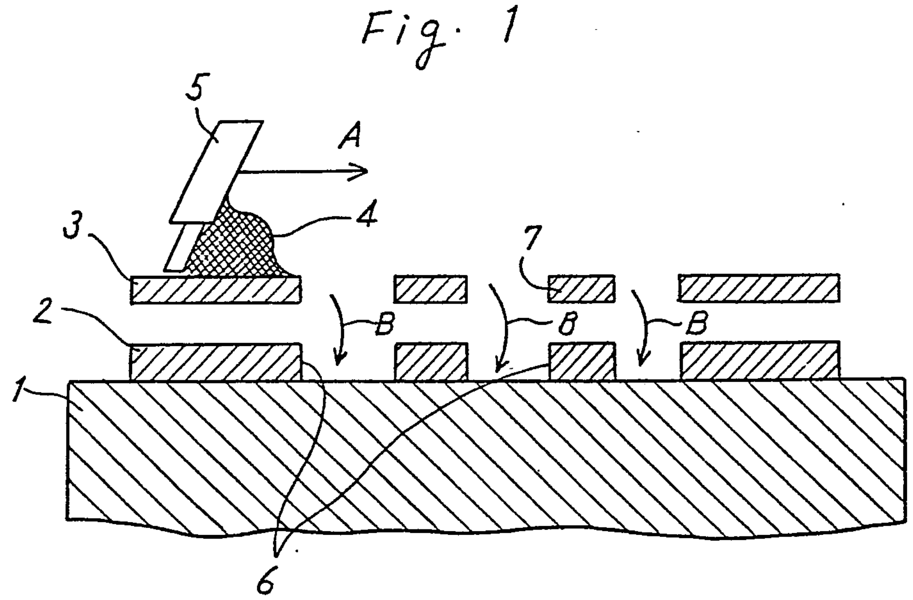

Fig·2

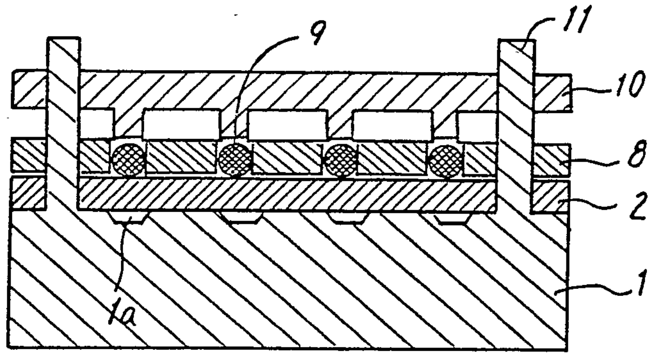


Fig·3

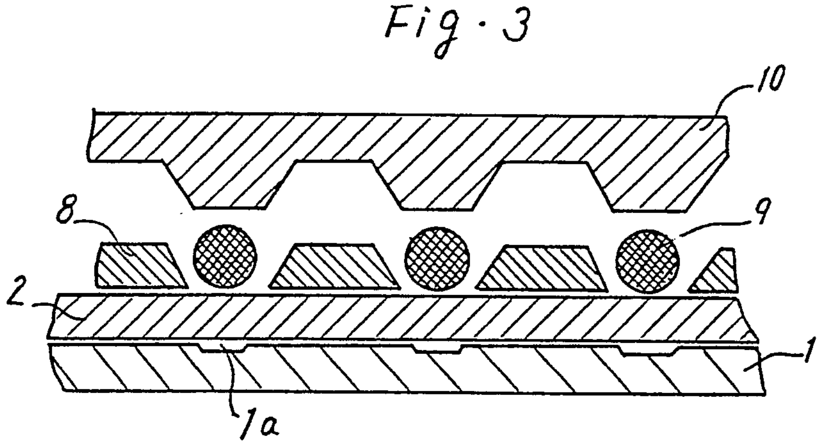


Fig·4

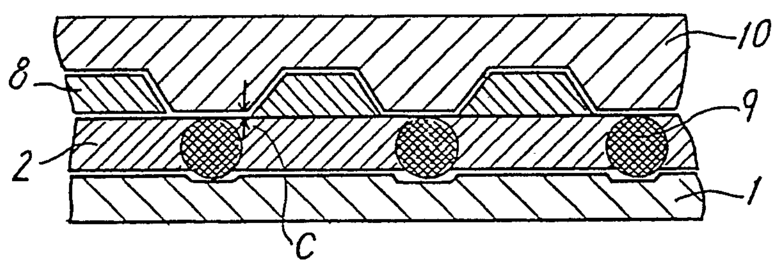

Fig. 5

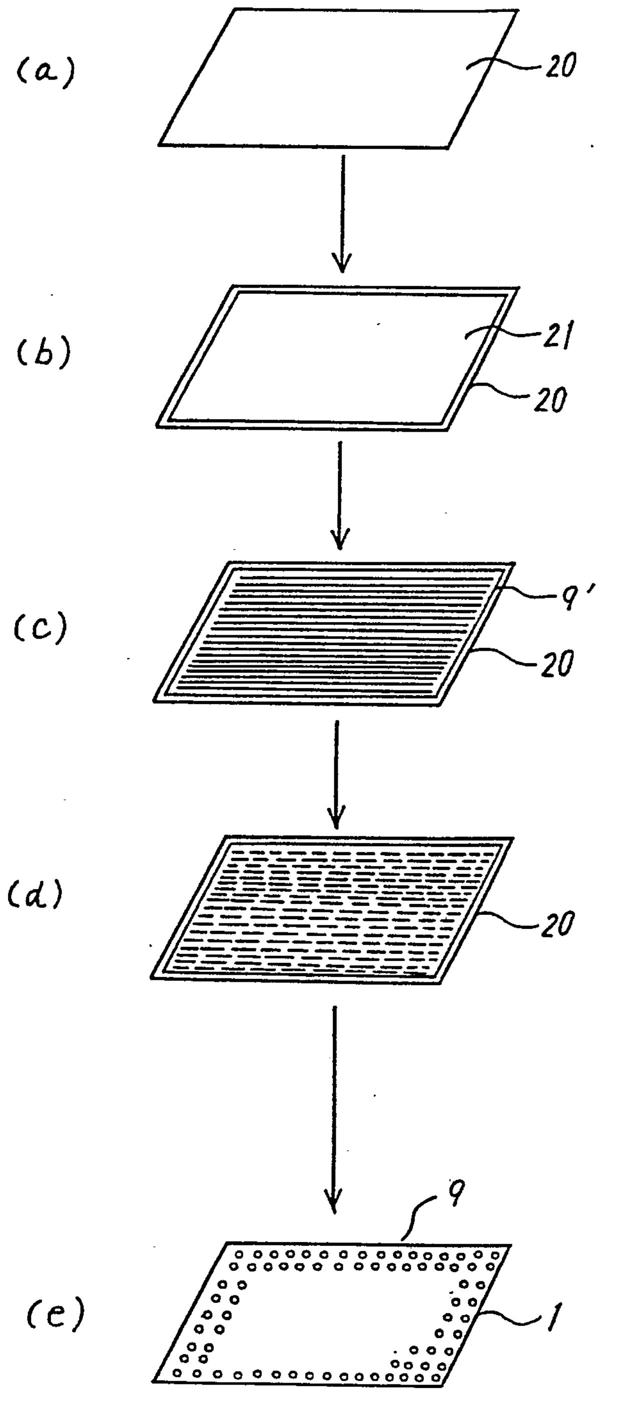

Fig. 6

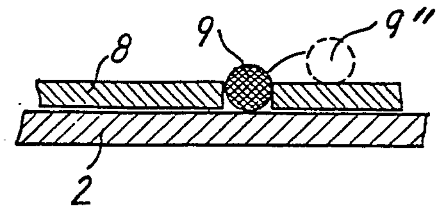


Fig. 7

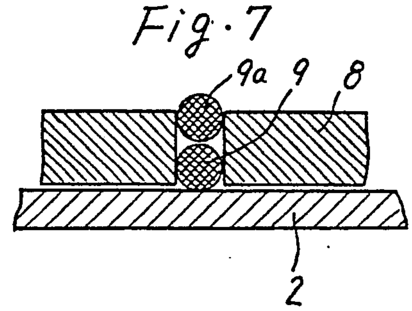


Fig. 8

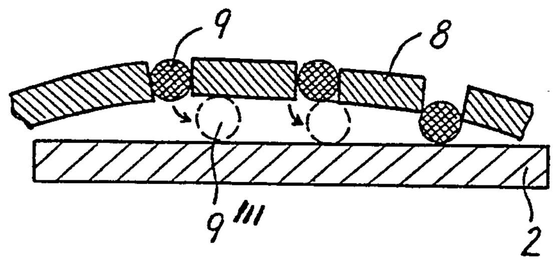


Fig. 9

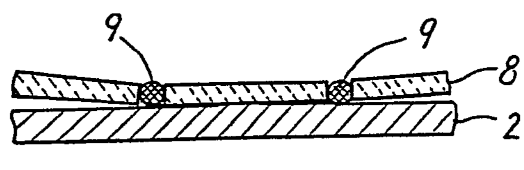


Fig. 10

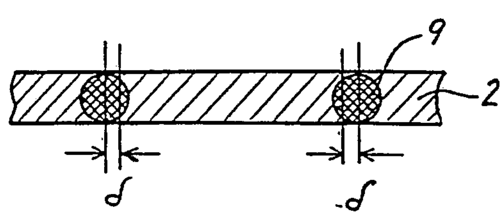

Fig. 11

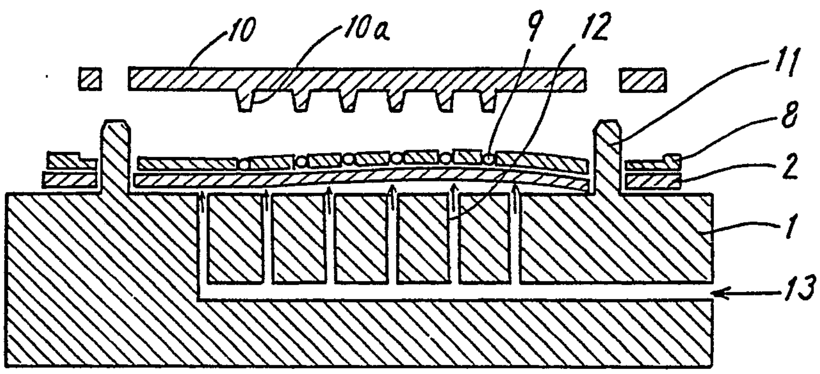


Fig. 12

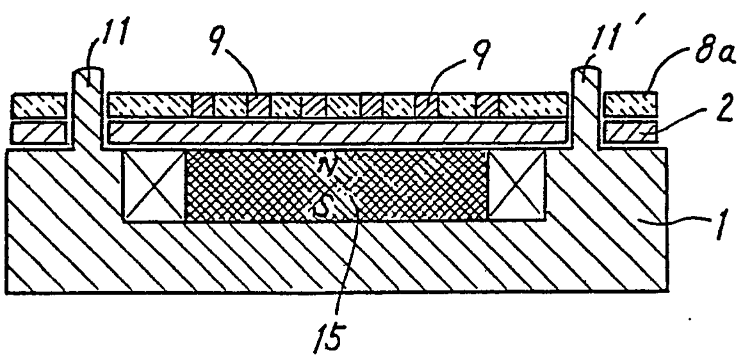

Fig·13

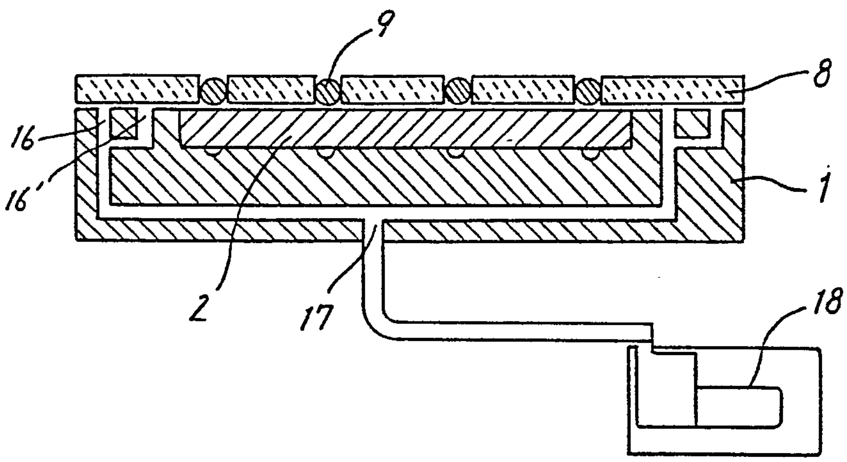


Fig·14

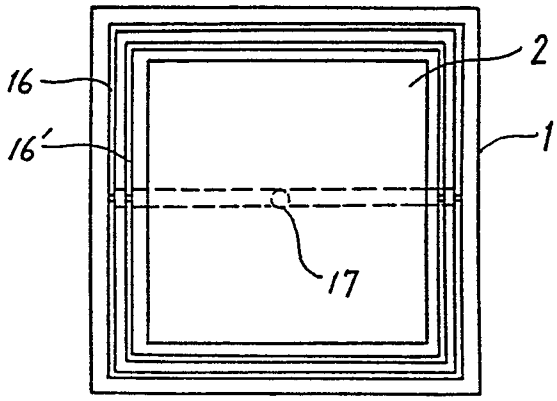

Fig. 15

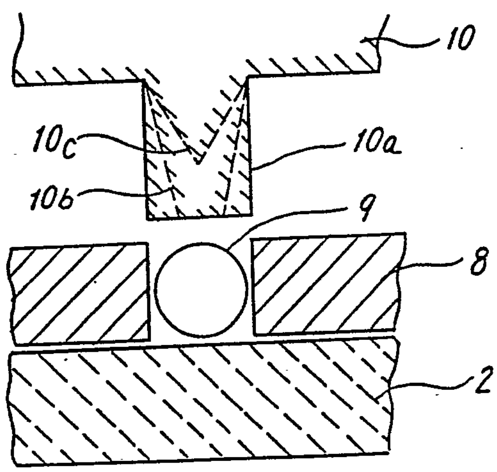

Fig. 16

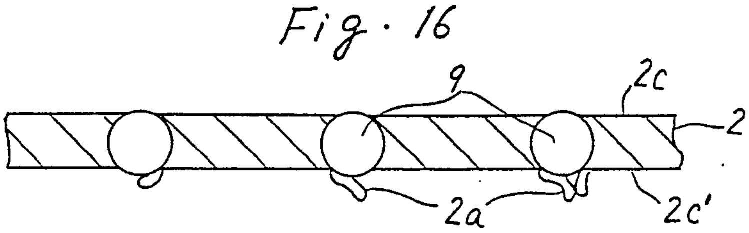


Fig. 17

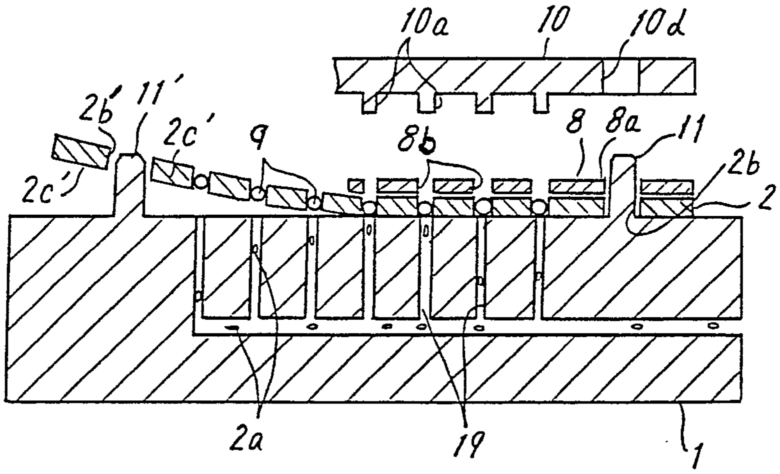


Fig. 18

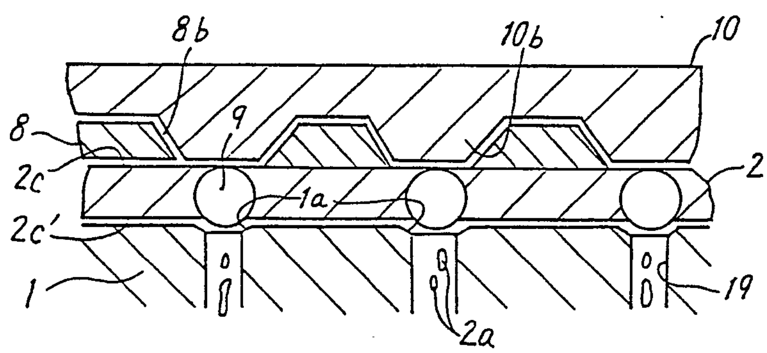

Fig. 19